# FASCICULE DE BREVET EUROPEEN

(11) **EP 1 438 722 B1**
(45) Date de publication et mention de la délivrance du brevet: **14.11.2007**
(21) Numéro de dépôt: 02785509.7
(22) Date de dépôt: 19.09.2002
(51) Int. Cl.: G11C 11/16, H01F 10/32

(54) **MEMOIRE MAGNETIQUE A SELECTION A L'ECRITURE PAR INHIBITION ET PROCEDE POUR SON ECRITURE**
MAGNETSPEICHER MIT SCHREIBSPERRAUSWAHL UND SCHREIBVERFAHREN DAFÜR
MAGNETIC MEMORY WITH WRITE INHIBIT SELECTION AND THE WRITING METHOD FOR SAME

(30) Priorité: 20.09.2001 FR 0112123
(43) Date de publication de la demande: 21.07.2004
(73) Titulaire: CENTRE NATIONAL DE LA RECHERCHE SCIENTIFIQUE (CNRS), 75794 Paris (FR)
(72) Inventeur: NOZIERES, Jean-Pierre, F-38700 CORENC (FR); RANNO, Laurent, F-38000 Grenoble (FR); CONRAUX, Yann, F-38000 Grenoble (FR)
(74) Mandataire: de Beaumont, Michel
(86) Numéro de dépôt international: PCT/FR2002/003209
(87) Numéro de publication internationale: WO 2003/025946

(56) Documents cités:
- WO-A-00/79540
- US-A- 4 771 347
- US-A1- 2001 019 461
- US-A1- 2002 089 874
- US-B1- 6 385 082
- PATENT ABSTRACTS OF JAPAN vol. 016, no. 186 (P-1347), 7 mai 1992 (1992-05-07) & JP 04 023293 A (TOSHIBA CORP), 27 janvier 1992 (1992-01-27)

## Description

### Domaine technique

La présente invention se rattache au domaine des mémoires magnétiques, et notamment des mémoires magnétiques à accès aléatoire non volatiles permettant le stockage et la lecture de données dans les systèmes électroniques. Plus précisément, elle concerne les mémoires à accès aléatoire magnétiques, appelées M-RAM, constituées d'une jonction tunnel magnétique.

### Etat Antérieur de la technique

Les mémoires basées sur l'état de charge d'une capacité (DRAM, SRAM, FLASH) deviennent de plus en plus sensibles aux radiations ionisantes (telles que par exemple les rayons cosmiques) au fur et à mesure que la dimension des transistors élémentaires se réduit. Par ailleurs, les mémoires à base de ferroélectriques (FRAM) présentent de sérieux problèmes de vieillissement. Les développements récents dans le domaine de la magnéto-électronique ont permis de concevoir un nouveau type de mémoire, basé sur la magnétorésistance de jonctions magnétiques. En d'autres termes, leur principe de fonctionnement ne repose plus sur le stockage d'une charge électrique, mais sur l'orientation relative de l'aimantation des éléments qui la constituent. Ces mémoires magnétiques à accès aléatoire (Magnetic Random Access Memories - MRAM) présentent de nombreux atouts : rapidité (quelques nanosecondes de durée d'écriture et de lecture), non volatilité, absence de fatigue à la lecture et à l'écriture, insensibilité aux radiations ionisantes. Elles sont susceptibles dans un premier temps, de remplacer les mémoires flash et, à plus long terme, les DRAM et SRAM pour devenir une mémoire universelle.

Dans les premières mémoires magnétiques, le point mémoire était constitué d'un élément dit à magnétorésistance géante, formé d'un empilement de plusieurs couches métalliques alternativement magnétiques et non magnétiques. Une description détaillée de ce type de structures peut être trouvée dans les documents US-A-4 949 039 et US-A-5 159 513 pour les structures de base, et dans le document US-A-5 343 422 pour la réalisation d'une mémoire RAM à partir de ces structures de base. Ce type de mémoire, de part son architecture, permet la réalisation de mémoires non volatiles avec une technologie simple, mais de capacité limitée. En effet, le fait que les éléments mémoire soient connectés en série le long de chaque ligne limite la possibilité d'intégration, puisque le signal est de plus en plus faible lorsque le nombre d'éléments augmente.

Les structures les plus prometteuses utilisent pour chaque point mémoire une jonction tunnel magnétique, appelée par la suite Magnetic Tunnel Junction - MTJ, et composées dans leur forme la plus simple, de deux couches magnétiques de coercitivités différentes, séparées par une mince couche isolante. Une description de ces structures est donnée dans la publication Physics Letters volume 54A (1975) page 225, ou plus récemment dans les publications Journal of Magnetism and Magnetic Materials volume 139 (1995) page L139 et Physical Review Letters volume 74 (1995) page 3273. L'utilisation de ces structures pour la fabrication de MRAM a été décrite initialement dans le document US-A-5 640 343.

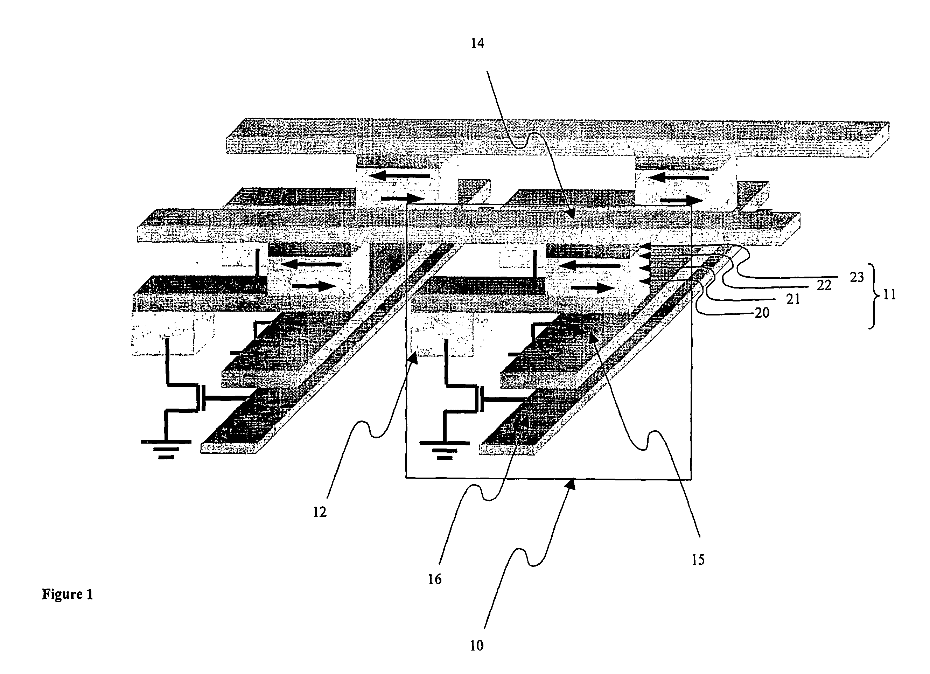

L'architecture la plus prometteuse pour l'instant semble être celle décrite dans le document US-A-6 021 065 et dans la publication Journal of Applied Physics volume 81 (1997) page 3758, et dont le principe est représenté schématiquement sur la figure 1. Comme on peut le voir sur la figure 1, chaque élément ou point mémoire (10) est constitué de l'association d'un transistor CMOS (12) et d'une jonction MTJ (11). La dite jonction (11) comporte au moins une couche magnétique (20), dite couche libre, une fine couche isolante (21) et une couche magnétique (22), dite couche piégée. Préférentiellement mais de manière non limitative, les deux couches magnétiques sont réalisées à base des métaux 3d (Fe, Co, Ni) et leurs alliages, et la couche isolante est constituée d'alumine (Al₂O₃). Préférentiellement, la couche magnétique (22) est couplée à une couche antiferromagnétique (23), dont la fonction est de piéger la couche (22), afin que son aimantation ne bascule pas lors de l'écriture. Préférentiellement aussi, la couche (22) peut être elle-même formée de plusieurs couches, ainsi que le décrit par exemple le document US-A-5 583 725 pour former une couche dite anitferromagnétique synthétique. Toutes ces variantes, ainsi que d'autres, sont bien connues de l'homme de métier.

L'architecture comporte en outre trois niveaux de lignes. Les deux niveaux de lignes (14) (word line) et (15) (bit line), généralement disposés à 90° l'un par rapport à l'autre, sont destinés à acheminer des impulsions électriques propres à créer un champ magnétique permettant la commutation de l'aimantation de la couche (20) lors du processus d'écriture. Ces impulsions de champ sont produites en envoyant des impulsions de courant courtes (typiquement 2 à 5 nanosecondes) et d'intensité de l'ordre de 10 mA le long des lignes (14) et (15). L'intensité de ces impulsions et leur synchronisation sont ajustées de sorte que seule l'aimantation du point mémoire se trouvant à la croisée de ces deux lignes peut commuter. Un niveau de ligne additionnel (16) (control line) est destiné à commander l'ouverture ou la fermeture du canal des transistors (12) pour pouvoir adresser chaque élément mémoire individuellement. Les transistors (12) sont utilisés comme des interrupteurs.

En mode écriture, le transistor (12) sélectionné est en mode bloqué ou OFF, aucun courant ne le traverse. On envoie une impulsion de courant I dans les deux lignes (14) et (15) correspondant au point mémoire (10) sélectionné. L'amplitude de l'impulsion de courant I est telle que le champ magnétique crée ne soit pas suffisant pour faire basculer les points mémoire sur les lignes (14) ou (15), sauf à l'intersection des dites lignes (14) et (15), où la contribution conjointe des deux lignes est suffisante pour faire basculer l'aimantation de la couche (20) du point mémoire.

En mode lecture, le transistor (12) est en mode saturé ou ON par l'envoi d'une impulsion de courant positive dans sa base à travers la ligne de commande (16), le courant qui le traverse est maximum. Un courant de mesure est ensuite envoyé dans la ligne (14), qui ne peut traverser que le seul point mémoire dont le transistor (12) est en position ON. Par ce courant, on effectue une mesure de la résistance de la jonction (11) du point mémoire (10) sélectionné. Par comparaison avec un point mémoire référence qui n'est pas décrit ici, l'état correspondant du point mémoire (10) (1 ou 0) est ainsi déterminé.

En décrivant le mécanisme d'écriture de ces points mémoire, on comprend clairement les limites de cette architecture :
- L'écriture étant assurée par un champ magnétique extérieur, elle est assujettie à la valeur du champ de retournement individuel de chaque point mémoire. Si la fonction de distribution des champs de retournement pour l'ensemble des points mémoire est large (en effet, elle n'est pas uniforme en raison des contraintes de construction), il est nécessaire que le champ magnétique sur le point mémoire sélectionné soit supérieur au champ de retournement le plus élevé de la distribution, au risque de renverser accidentellement certains points mémoire situés sur la ligne et ou la colonne correspondante, dont le champ de retournement, situé dans la partie basse de la distribution, est plus faible que le champ magnétique généré par la ligne ou la colonne seule. Inversement, si l'on souhaite s'assurer qu'aucun point mémoire ne soit écrit par une ligne ou une colonne seule, il faut limiter le courant d'écriture de façon à ne jamais dépasser pour ces points mémoire le champ magnétique correspondant à la partie basse de la distribution, au risque de ne pas écrire le point mémoire sélectionné à l'intersection desdites lignes et colonnes, si son champ de retournement est dans la partie haute de la distribution. En d'autres termes, cette architecture à sélection par champ magnétique à l'aide de lignes et de colonnes de conducteurs peut facilement conduire à des erreurs d'adressage à l'écriture. Compte tenu de ce qu'il est attendu que la fonction de distribution des champs de retournement des points mémoire soit d'autant plus large que leur dimension est faible, puisque c'est la géométrie des points mémoire (forme, irrégularités, défauts) qui domine le renversement de l'aimantation, cet effet ne pourra qu'empirer dans les générations de produits futures.
- En outre, ce mode d'écriture ne permet d'écrire qu'un seul point mémoire à la fois pour minimiser le risque d'erreur d'adressage.

L'objet de la présente invention consiste précisément à s'affranchir de ces limitations.

### Descriptif sommaire de l'invention

L'invention vise une mémoire magnétique de type MTJ, qui minimise les erreurs d'adressage en inhibant à l'écriture les points mémoire qui ne doivent pas être écrits. Pour cela, elle propose de remplacer les couches ferromagnétiques usuelles (20, 22) du type de celles décrites en relation avec la figure 1 à base de métaux 3d (Fe, Co, Ni) et leurs alliages, par des alliages amorphes ferrimagnétiques (AAF).

Elle propose donc une mémoire magnétique, dont chaque point mémoire est constitué d'une jonction tunnel magnétique, comprenant :
- une couche magnétique, dite couche piégée, dont l'aimantation est rigide,
- une couche magnétique, dite couche libre, dont l'aimantation peut être inversée,
- une couche isolante, interposée entre la couche libre et la couche piégée et au contact respectif de ces deux couches.

Selon l'invention, la couche libre est réalisée en un alliage amorphe ou nanocristallisé à base de terre rare et d'un métal de transition, l'ordre magnétique dudit alliage étant de type ferrimagnétique, et la température de fonctionnement de la mémoire est choisie proche de la température de compensation dudit alliage.

La température de compensation est définie comme étant la température à laquelle les aimantations respectives du sous réseau des atomes de terres rares et du sous réseau de métaux de transition entrant dans la composition de l'AAF sont parfaitement compensées, c'est à dire qu'elles sont égales en amplitude et opposées en signe, donc l'aimantation macroscopique résultante est nulle.

Chacun des points mémoire est placé à l'intersection d'un réseau de conducteurs électriques, avantageusement des connecteurs croisés, et connecté à sa base à un transistor de sélection et sur la partie supérieure à l'un desdits connecteurs croisés.

Dans une première forme de l'invention, l'écriture est réalisée au niveau d'un point mémoire considéré par l'envoi simultané d'impulsions de courant électrique dans lesdits conducteurs croisés, afin de générer un champ magnétique d'écriture sur ledit point mémoire à écrire, et d'un courant de chauffage par le biais dudit transistor.

Selon une autre forme de réalisation de l'invention, l'écriture est réalisée en envoyant des impulsions de courant dans les conducteurs croisés correspondant audit point mémoire à écrire, et en chauffant les points mémoire que l'on souhaite éviter d'écrire (points mémoire à inhiber) par le biais des transistors correspondants, ledit courant de chauffage étant sélectionné de telle sorte que la température desdits points mémoire à inhiber devienne supérieure à la température de compensation de l'alliage ferrimagnétique constitutif de la couche libre desdits points mémoire, lesdits points mémoire à inhiber présentant ainsi l'aimantation de leur couche libre orientée selon la même direction que celle de la couche libre du point mémoire à écrire.

La manière dont l'invention peut être réalisée, et les avantages qui en découlent ressortiront mieux des exemples de réalisation qui suivent, donnés à titre indicatif et non limitatif à l'appui des figures annexées

### Description sommaire des figures

La figure 1, déjà décrite, est une représentation schématique de l'architecture d'une mémoire magnétique de l'état antérieur de la technique, dont les points mémoire sont constitués par une MTJ.
La figure 2a est une représentation schématique de l'aimantation d'un AAF.
La figure 2b est une courbe représentant la variation de l'aimantation d'un AAF en fonction de la température.
La figure 3 est une représentation schématique d'une mémoire magnétique conforme à une première forme de réalisation de l'invention.
La figure 4 est une courbe représentative de la variation du champ magnétique de retournement de la couche libre d'AAF d'une MTJ de la mémoire de l'invention en fonction de la température.
Les figures 5a à 5d illustrent le mode de fonctionnement de la mémoire magnétique selon une autre forme de réalisation de l'invention.
Les figures 6a à 6c illustrent le mode de fonctionnement de l'inhibition d'un point mémoire correspondant à la configuration de la figure 5d.

### Description détaillée de l'invention

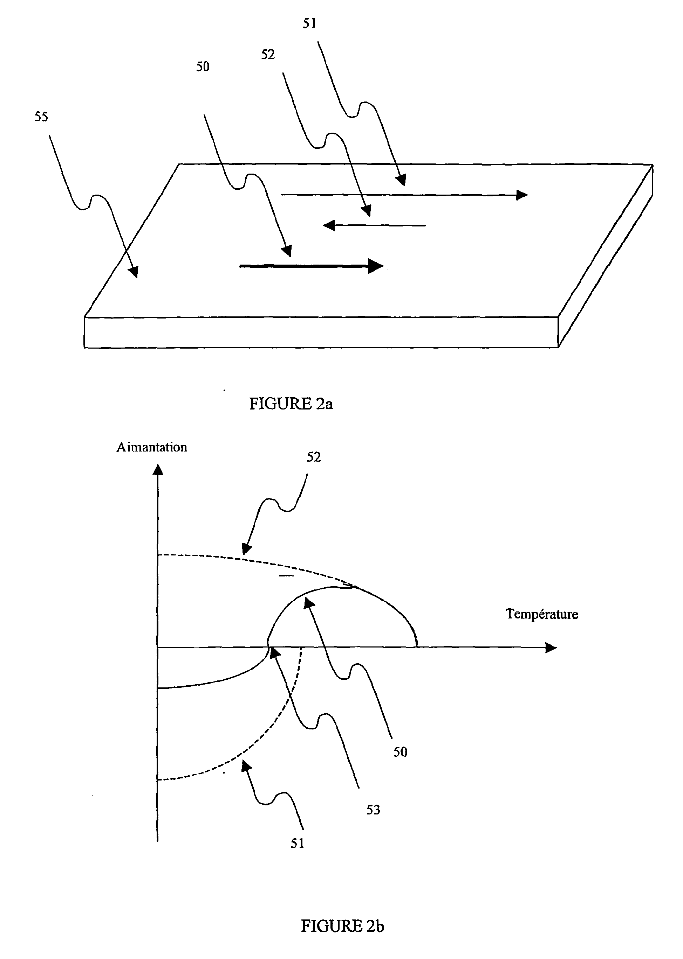

Ainsi que brièvement rappelé ci-dessus, le fonctionnement de la mémoire conforme à l'invention repose sur la mise en oeuvre d'une phase de chauffage de la couche libre d'AAF de la MTJ des poins mémoire la constituant. La référence de cette élévation de température est constituée par la température dite de compensation. Il va donc être tout d'abord rapidement détaillé ce phénomène.
Ainsi qu'on peut l'observer sur la figure 2a, l'aimantation macroscopique (50) d'une couche (55) d'un AAF peut être décomposée en deux contributions, une contribution due au sous réseau des atomes de terre rare (51), et une contribution due au sous réseau des atomes de métal de transition (52). De façon schématique, l'aimantation macroscopique (50) résulte de la somme vectorielle des aimantations des deux sous réseaux (51) et (52).

Par ailleurs, les aimantations du sous réseau de terre rare (51) et du sous réseau du métal de transition (52) sont fortement couplées entre elles, résultant en un comportement conjoint lors du renversement de l'aimantation macroscopique (50) ou de la réorientation par une excitation sélective de l'un des sous réseaux (51) et (52).

En outre, lorsque la nature chimique et la composition relative de la terre rare et du métal de transition sont judicieusement choisies, l'ordre magnétique est de type ferrimagnétique, c'est à dire que l'aimantation du sous-réseau des atomes de terre rare (51) pointe dans une direction tandis que l'aimantation du sous réseau des atomes de métal de transition (52) pointe dans la direction opposée. Comme on peut le voir sur la figure 2a, si la valeur absolue des aimantations (51) et (52) des deux sous-réseaux n'est pas égale, le moment magnétique macroscopique (50) de l'ensemble de l'AAF est non nul.

Par ailleurs, comme on le voit sur la figure 2b, les variations en température des aimantations (51) du sous réseau de la terre rare, et (52) du métal de transition sont très différentes, conduisant à une variation avec la température de l'importance relative de contributions des deux sous réseaux à l'aimantation macroscopique résultante. En règle générale, l'aimantation du sous réseau de terre rare (51) décroît plus vite que l'aimantation du sous réseau de métal de transition (52). Lorsque la nature chimique et la composition relative de la terre rare et du métal de transition sont judicieusement choisies, pour que les aimantations (51) et (52) des deux sous-réseaux soient antiparallèles, il existe une température, appelée température de compensation (53), à laquelle ces deux aimantations sont parfaitement compensées, c'est à dire qu'elles sont égales en amplitude et opposées en signe, donc l'aimantation macroscopique (50) résultante est nulle. En dessous de la température de compensation, le sous réseau de terre rare (51) domine et définit la direction de l'aimantation macroscopique (50). Au-dessus de la température de compensation, le sous réseau de métal de transition (52) domine et détermine la direction de l'aimantation macroscopique (50).

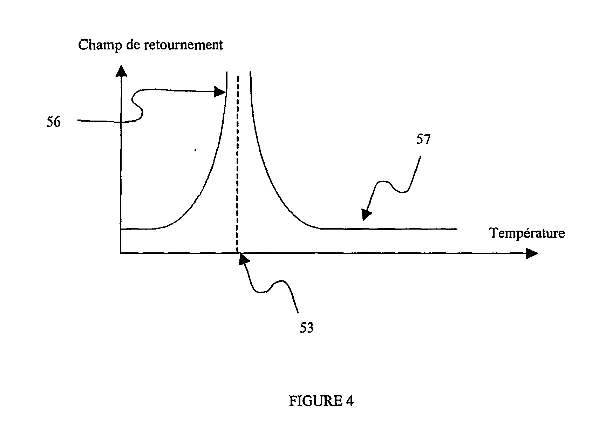

Par ailleurs, à la température de compensation (53), le champ coercitif diverge et tend vers l'infini (voir figure 4). De part et d'autre de la température de compensation, le champ coercitif décroît d'autant plus rapidement que la température est proche de la température de compensation (53).

Par ailleurs, les électrons contribuant à l'aimantation du sous réseau de métal de transition (52) sont principalement les électrons de conduction (électrons 3d), c'est à dire les électrons qui participent au transport du courant électrique. Par contre, les électrons responsables de l'aimantation du sous réseau de terre rare (51) sont les électrons des niveaux de coeur (électrons 4f), qui sont localisés et fortement écrantés par les autres électrons du système.

Enfin, les propriétés intrinsèques de ces AAF (aimantation macroscopique, anisotropie magnétique, champ coercitif) peuvent être très facilement contrôlées par la nature chimique des éléments mis en jeu et leurs concentrations respectives. On peut également pour cela rajouter des faibles quantités d'éléments de substitution, en général des métaux de transition, des métaux réfractaires ou des terres rares, par exemple mais de manière, non limitative du Ta, Mo, Nb, Zr, Pt, Dy, et Sm.

Parmi les AAF envisagés dans la présente invention, on trouve de manière préférentielle mais non limitative l'alliage amorphe de Gadolinium (Gd) et de Cobalt (Co), qui associe un ordre ferrimagnétique, une faible anisotropie magnétocristalline, et lorsque la composition est judicieusement choisie, une température de compensation proche de la température de fonctionnement de la mémoire, par exemple Gd₂₅Co₇₅.

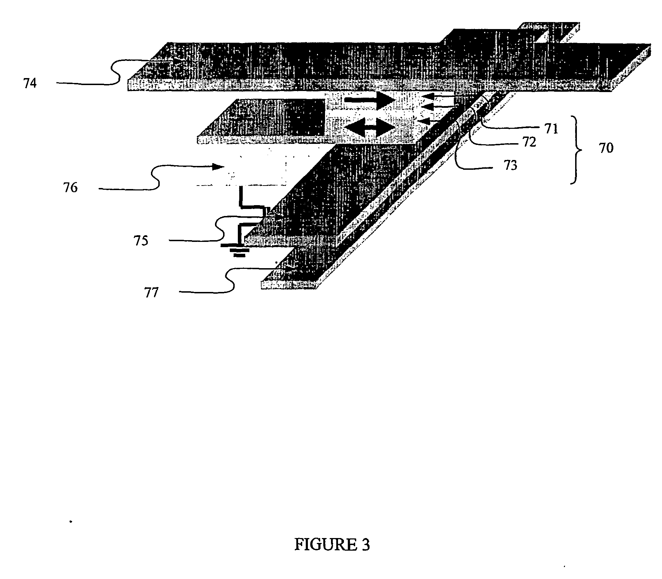

Comme on peut le voir sur la figure 3, le point mémoire d'une mémoire magnétique conforme à l'invention est formé d'une MTJ (70) de type AAF comportant une couche magnétique (71), dont l'aimantation est piégée, une couche isolante (72) réalisée en alumine, et une couche d'alliage AAF (73), dont on souhaite renverser l'aimantation pour écrire le point mémoire (70). Deux lignes d'amenée de courant (74) et (75) se croisent à l'aplomb du point mémoire. La ligne de conducteur supérieure (74) est au contact de la MTJ (70). La ligne de conducteur inférieure (75) est isolée électriquement de ladite MTJ. Un transistor de commande (76) et sa ligne de commande (77) sont placés sous et au contact du point mémoire (70). Tout cela est similaire à l'état antérieur de la technique, hormis la nature chimique des couches (71) et (73).

Avantageusement une couche de forte coercitivité, par exemple un alliage à base de

Co, ou une couche antiferromagnétique, par exemple un alliage ordonné PtMn (non représentée) peut être placée sur la couche (71) pour bloquer son aimantation.

Avantageusement la couche magnétique (71) peut être formée d'un alliage AAF, identique ou différent de la couche (73), dont le champ de retournement est grand, par exemple un alliage à base de Samarium et de Cobalt ou encore en un alliage amorphe à base de Terbium et de Cobalt.

Un point mémoire conforme à l'invention fonctionne de la façon suivante, illustré en relation avec la figure 4 :
La température de fonctionnement (56) de la mémoire est choisie proche de la température de compensation (53) de la couche (73), de façon à garantir des champs de retournement des points mémoire importants, puisque celui-ci diverge à la température de compensation (53). Avantageusement, la température de compensation de la couche (73) est légèrement inférieure à la température de fonctionnement de la mémoire.

A l'écriture, par une impulsion dans la ligne (77), on ouvre le transistor de commande (76) correspondant au point mémoire (70) sélectionné. Le courant qui passe dans le point mémoire est choisi suffisant pour échauffer ce dernier à une température (57) très supérieure à la température de compensation (53), l'échauffement étant facilité par la résistivité importante des alliages AAF utilisés dans la couche (73). A cet échauffement du point mémoire (70), est associé une chute brutale du champ de retournement de la couche (73) puisque celui-ci varie très vite au voisinage de la température de compensation. On envoie alors une impulsion de courant dans les conducteurs d'excitation (74) et (75), avec un signe tel qu'elle permette le renversement de l'aimantation de la couche (73). Une fois que l'aimantation de la couche (73) a été retournée par l'impulsion de courant dans les lignes (74) et (75), le courant de chauffage dans la ligne (77) est coupé, ce qui ramène la température du point mémoire (70) en dessous de la température de compensation (53) et les impulsions de courant dans les conducteurs (74) et (75) sont supprimées. Le point mémoire est écrit.

A la lecture, le procédé est identique à celui décrit dans l'état antérieur de la technique, à savoir une lecture de la résistance du point mémoire par un courant de faible amplitude dans la ligne (77), laquelle résistance est comparée à celle d'une cellule de référence qui n'est pas décrite sur la figure 3.

On conçoit l'intérêt de cette architecture en considérant que le champ de retournement varie énormément avec la température au voisinage de la température de compensation (53). En conséquence, il est possible d'abaisser le champ de retournement du point mémoire sélectionné à des valeurs très inférieures à celles des autres points mémoire du réseau. En particulier le champ de retournement du point mémoire sélectionné peut être obtenu inférieur à la borne inférieure de la distribution de champs de retournement de l'ensemble de la mémoire. L'amplitude de l'impulsion de courant est donc suffisante pour renverser l'aimantation du point mémoire, mais pas pour renverser l'aimantation des points mémoire non sélectionnés, dont la température reste proche de la température de fonctionnement, et ce, quelle que soit la valeur du champ de retournement dans la distribution dudit champ de retournement de l'ensemble des points mémoire du réseau. On augmente ainsi fortement la sélectivité à l'écriture, ce qui a pour effet d'éliminer les erreurs d'adressage observées dans l'état antérieur de la technique.

L'utilisation d'un chauffage pour favoriser la sélection d'un point mémoire est également possible avec des MTJ à base d'alliage de métaux 3d, comme dans l'état de l'art, mais la variation beaucoup plus lente du champ de retournement avec la température dans ces alliages oblige à chauffer à des températures beaucoup plus élevées, résultant en une puissance consommée et un durée de lecture plus grands.

Avantageusement, le courant de chauffage peut être obtenu par un élément chauffant extérieur non représenté sur la figure 3.

Avantageusement, cette technique d'adressage permet l'écriture simultanée de plusieurs points mémoire, en sélectionnant le chauffage simultané de plusieurs points mémoire. Cette approche permet d'augmenter la vitesse d'écriture globale de la mémoire.

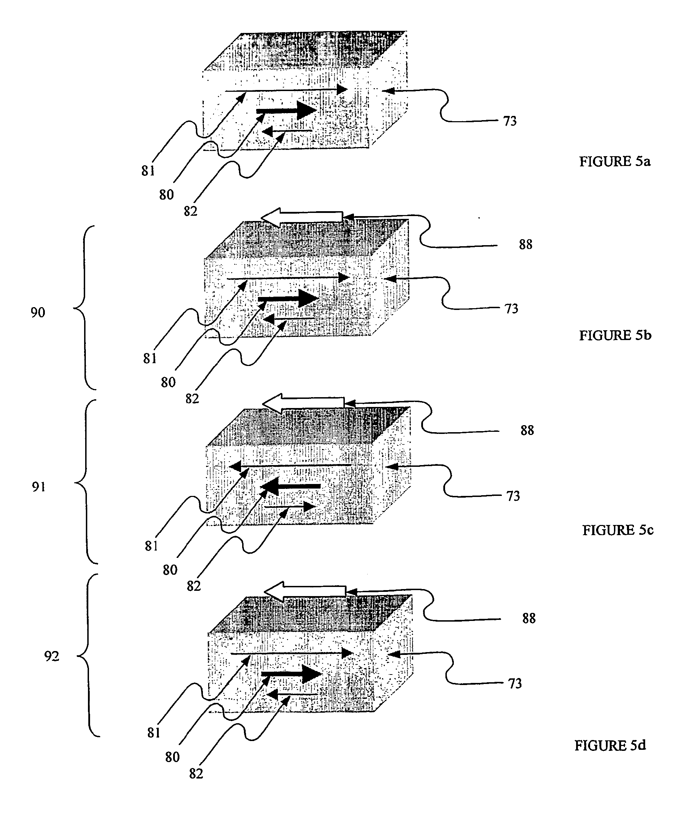

Dans une variante améliorée dé l'invention, la sélection à l'adressage est obtenue en inhibant les points mémoire que l'on ne souhaite pas écrire par un chauffage identique à celui utilisé pour le point sélectionné dans la forme de réalisation décrite précédemment. Dans ce cas comme on peut le voir sur la figure 5a, on sélectionne la nature chimique et la composition de la couche (73), de telle sorte qu'à la température de fonctionnement au repos de la mémoire, le moment magnétique du sous réseau des atomes de terre rare (81) soit supérieur au moment magnétique du sous réseau des atomes de métal de transition (82). En conséquence l'aimantation macroscopique (80) de la couche (73) pointe dans la même direction que l'aimantation du sous réseau (81). Par ailleurs, la température de fonctionnement au repos de la mémoire est choisie inférieure à la température de compensation (53) de la couche (73). Le processus d'écriture est alors le suivant :
On envoie par le biais des conducteurs (74) et (75) un courant d'amplitude telle, que le champ magnétique (88) créé à l'intersection desdits conducteurs correspondant au point mémoire à écrire possède un signe opposé à l'aimantation au repos du point mémoire (90) à écrire, dont seule la couche (73) à renverser est représentée sur la figure 5b. L'amplitude du champ magnétique d'écriture (88) ainsi créé est très supérieure au champ de retournement du point mémoire (90) sélectionné pour s'assurer de son écriture sans erreur quelle que soit la distribution de champ de retournement du réseau de points mémoires.

Simultanément, les autres points mémoire que l'on ne souhaite pas écrire sont inhibés selon la procédure suivante : Si le point mémoire (91), constituant l'un des points mémoire à inhiber, dont seule la couche (73) est représentée sur la figure 5c, possède une aimantation macroscopique (80) de sens opposé à l'aimantation du point mémoire (90) à écrire, le champ magnétique (88) est nécessairement de même sens que l'aimantation (80) dudit point mémoire (91), c'est donc un champ stabilisant. En conséquence l'état du point mémoire (91) n'est pas affecté, quelle que soit l'amplitude du champ magnétique (88) appliqué.

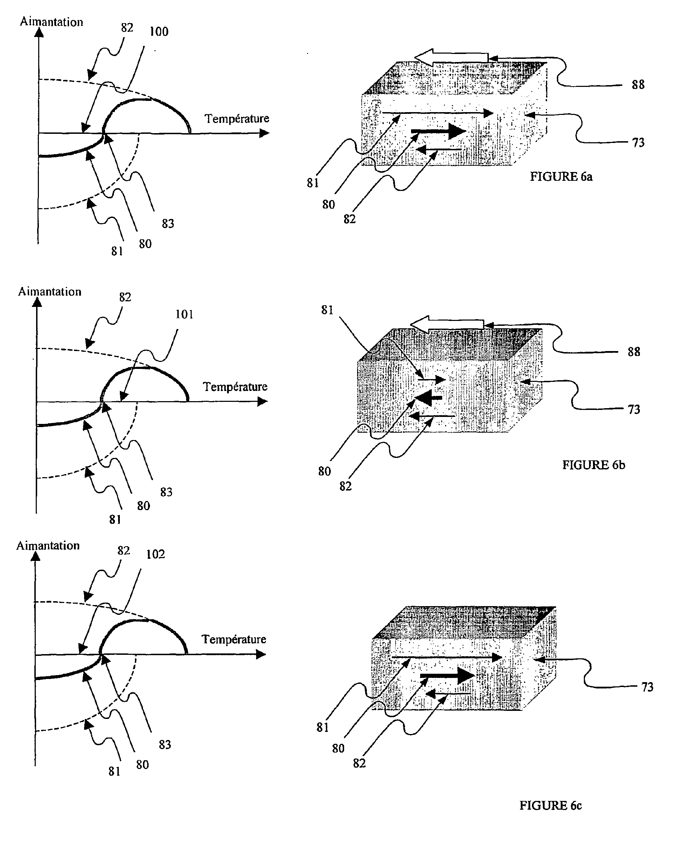

Si le point mémoire (92), constituant également l'un des points mémoire à inhiber, dont seule la couche (73) est représentée sur la figure 5d, possède une aimantation macroscopique (80) de même sens que le point mémoire (90) à écrire, le champ magnétique (88) est opposé à l'aimantation (80) au repos, il y a donc risque d'écriture erronée. On inhibe alors l'écriture du point mémoire (92) par la procédure suivante: Comme on peut le voir sur la figure 6a, où seule la couche (73) du point mémoire (92) est représentée, à partir de la température au repos (100) du point mémoire (92), au dessous de la température de compensation (83), en commandant, avant l'envoi d'impulsions de courant dans les lignes (74) et (75), l'ouverture du transistor (76) correspondant au point mémoire (92) par l'envoi d'une impulsion de courant dans la ligne (77) correspondante, on chauffe le point mémoire (92) à une température (101) au-dessus de la température de compensation (83) de la couche (73) correspondante. En raison des propriétés spécifiques des alliages AAF, le passage au-dessus de la température de compensation (83) a pour effet de renverser l'aimantation macroscopique (80) du point mémoire (92), puisque les contributions relatives de l'aimantation du sous réseau des atomes de terre rare (81) et de l'aimantation du sous réseau des atomes de métal de transition (82) s'inversent. Par cette procédure de chauffage, l'aimantation macroscopique (80) du point mémoire (92) à inhiber est maintenant de sens opposé à ce qu'elle était avant le chauffage, et le champ magnétique d'écriture (88) généré par les conducteurs (74) et (75) est maintenant un champ stabilisant : l'aimantation du point mémoire n'est pas renversée. Lorsque l'écriture du point mémoire (90) sélectionné est terminée, on stoppe d'abord le champ d'écriture (88) en coupant le courant dans les conducteurs (74) et (75), puis on coupe le chauffage du point mémoire (92) à inhiber. La couche (73) correspondante se refroidit au-dessous de sa température de compensation et retrouve son état d'aimantation initiale à la température (102) en dessous de la température de compensation (83), comme on peut le voir sur la figure 6c, dans laquelle seule la couche (73) a été représentée. Ainsi par cette procédure, l'écriture du point mémoire (92) est inhibée bien que le sens et l'amplitude du champ d'écriture (88) aient correspondu à un champ d'écriture.
L'intérêt de cette technique d'inhibition est d'éliminer toutes les erreurs d'adressage potentielles, puisque le champ d'écriture est un champ stabilisant sur tous les points mémoire, quel que soit leur état d'aimantation au repos, sauf sur le point mémoire sélectionné pour lequel il peut donc être très supérieur au champ de retournement moyen. Les erreurs d'adressage sont donc impossibles.

Avantageusement, cette technique d'adressage par inhibition permet également d'écrire plusieurs points mémoire simultanément, puisque la sélection est réalisée par l'inhibition des autres points mémoire. Le processus d'écriture peut avantageusement être réduit à deux étapes : l'écriture simultanée de l'ensemble des points mémoire dans une direction donnée, en saturant tous les conducteurs correspondants et en inhibant les points mémoire de la direction opposée, et l'écriture simultanée de l'ensemble des points mémoire dans l'autre direction en inversant les sélections d'écriture (ainsi que le signe du courant d'écriture) et de chauffage. Par cette approche on maximalise la vitesse d'écriture globale de la mémoire.

Avantageusement, le courant de chauffage peut être obtenu par un élément chauffant extérieur non représenté sur la figure 3.

Avantageusement, la structure de la mémoire n'utilise qu'un seul conducteur d'excitation puisque l'amplitude du champ d'écriture (88) n'étant plus le critère de sélection du point mémoire à écrire, il n'est plus nécessaire d'utiliser deux conducteurs croisés pour sélectionner le point mémoire à écrire à leur intersection seulement. Dans ce cas, la mémoire est formée d'un conducteur unique (supérieur) d'excitation de champ (74), et d'un conducteur de commande des transistors (inférieur) de chauffage (77). Cette architecture permet de supprimer la ligne d'excitation inférieure (75), ce qui permet de minimiser la dimension de la cellule élémentaire, puisqu'il n'y a plus a décaler la ligne de transistor de commande (77) par rapport au point mémoire (70) pour permettre le passage de la ligne de courant inférieure (75). Les possibilités d'intégration s'en trouvent de fait accrues et les procédés de fabrication sont simplifiés.

## Revendications

1. Mémoire magnétique, dont chaque point mémoire est constitué d'une jonction tunnel magnétique (70), comprenant :
• une couche magnétique, dite couche piégée (71), dont l'aimantation est rigide ;
• une couche magnétique, dite couche libre (73), dont l'aimantation peut être inversée ;
• une couche isolante (72), interposée entre la couche libre (73) et la couche piégée (71) et au contact respectif de ces deux couches ,
***caractérisée* en ce que** la couche libre (73) est réalisée en un alliage amorphe ou nanocristallisé à base de terre rare et d'un métal de transition, l'ordre magnétique dudit alliage étant de type ferrimagnétique, et **en ce que** la mémoire magnétique comprend des moyens (76) apte à choisir la température de fonctionnement de la mémoire proche de la température de compensation dudit alliage.

2. Mémoire magnétique selon la revendication 1, ***caractérisée* en ce que** la couche libre (73) est réalisée à base d'un alliage de Gadolinium et de Cobalt.

3. Mémoire magnétique selon l'une des revendications 1 et 2, ***caractérisée* en ce que** la couche libre (73) intègre en outre en faible quantité un ou plusieurs éléments de substitution.

4. Mémoire magnétique selon la revendication 3, ***caractérisée* en ce que** les éléments de substitution sont choisis dans le groupe comprenant par exemple le Zr, Ta, Mo, Nb, Dy, Sm, Pt.

5. Mémoire magnétique selon l'une des revendications 1 à 4, ***caractérisée* en ce que** la couche piégée (71) est réalisée en un alliage amorphe à base de terre rare et d'un métal de transition, identique ou différent de celui constitutif de la couche libre (73), l'ordre magnétique dans ledit alliage étant de type ferrimagnétique.

6. Mémoire magnétique selon la revendication 5, ***caractérisée* en ce que** la couche piégée (71) est réalisée en un alliage amorphe à base de Terbium et de Cobalt.

7. Mémoire magnétique selon l'une des revendications 1 à 4, ***caractérisée* en ce que** la couche piégée (71) est réalisée en un alliage amorphe à base de terre rare et d'un métal de transition, l'ordre magnétique dans ledit alliage étant de type ferromagnétique ,

8. Mémoire magnétique selon la revendication 7, ***caractérisée* en ce que** la couche piégée (71) est réalisée en un alliage de samarium et de cobalt.

9. Mémoire magnétique selon l'une des revendications 1 à 8, ***caractérisée* en ce que** chacun de ses points mémoire est placé à l'intersection d'un réseau de conducteurs électriques (74, 75), ledit conducteur inférieur (75) étant isolé électriquement desdits points mémoire, chacun desdits points mémoire étant connecté à sa base à un transistor de sélection (76), l'écriture étant réalisée au niveau d'un point mémoire considéré par l'envoi simultané d'impulsions de courant électrique dans lesdits conducteurs (74, 75) et d'un courant de chauffage par le biais dudit transistor (76).

10. Mémoire magnétique selon l'une des revendications 1 à 9, ***caractérisée* en ce que** la température du point mémoire lors de l'écriture est portée à une valeur supérieure à la température de compensation (53) de la couche libre (73) qui le constitue.

11. Mémoire magnétique à accès aléatoire conforme à l'une quelconque des revendications 1 à 10.

12. Procédé pour écrire dans une mémoire magnétique selon la revendication 1 dont chacun des points mémoire étant placé à l'intersection d'un réseau de conducteurs électriques (74, 75), ledit conducteur inférieur (75) étant isolé électriquement desdits points mémoire, chacun desdits points mémoire étant connecté à sa base à un transistor de sélection (76),
***caractérisé* en ce qu'**il consiste :
• à choisir la température de fonctionnement de la mémoire proche de la température de compensation dudit alliage ; et
• à envoyer simultanément au niveau du point mémoire à écrire des impulsions de courant électrique dans lesdits conducteurs (74, 75) correspondants et un courant de chauffage par le biais dudit transistor (76) considéré.

13. Procédé pour écrire dans une mémoire magnétique selon la revendication 1 dont chacun des points mémoire étant placé à l'intersection d'un réseau de conducteurs électriques (74, 75), ledit conducteur inférieur (75) étant isolé électriquement desdits points mémoire, chacun d'entre eux étant connecté à sa base à un transistor de sélection (76),
***caractérisé* en ce qu'**il consiste :
• à choisir la température de fonctionnement de la mémoire inférieure à la température de compensation dudit alliage ; et
• à envoyer simultanément au niveau du point mémoire à écrire des impulsions de courant électrique dans lesdits conducteurs (74, 75) correspondants et, au niveau des points mémoire à inhiber, lesdits points mémoire à inhiber (92) présentant l'aimantation (80) de leur couche libre (73) orientée selon la même direction que celle de 1a couche libre du point mémoire à écrire (90), un courant de chauffage par l'ouverture des transistors (76) correspondant connectés aux points mémoire à inhiber, ledit courant de chauffage étant sélectionné de telle sorte que la température desdits points mémoire à inhiber devienne supérieure à la température de compensation de l'alliage ferrimagnétique constitutif de la couche libre (73) desdits points mémoire.

14. Procédé pour écrire dans une mémoire magnétique selon la revendication 13, ***caractérisé* en ce qu'**un champ magnétique appliqué sur le point mémoire à écrire par les impulsions de courant électrique transitant par le biais des conducteurs électriques (74, 75) ait une amplitude très nettement supérieur au champ magnétique individuel de retournement de l'aimantation de la couche libre (73) dudit point mémoire à écrire.

15. Procédé pour écrire dans une mémoire magnétique selon l'une des revendications 13 et 14, ***caractérisé* en ce que** plusieurs points mémoire sont écrits simultanément.

16. Procédé pour écrire dans une mémoire magnétique se présentant sous la forme d'une matrice selon l'une des revendications 13 à 15, ***caractérisé* en ce que** l'on procède simultanément à l'écriture de l'ensemble des points mémoire d'une des deux états (directions) de la mémoire.

17. Procédé pour écrire dans une mémoire magnétique selon la revendication 16, ***caractérisé* en ce que** l'on procède à l'écriture de l'intégralité de la mémoire en deux opérations :
• une première opération dans laquelle on procède à l'écriture des points mémoire dans une direction donnée ;
• une seconde opération dans laquelle on procède à l'écriture des points mémoire dans l'autre direction.

18. Procédé pour écrire dans une mémoire magnétique selon la revendication 13, ***caractérisé* en ce que** l'écriture sur chacun des points mémoire est obtenue par une impulsion de courant électrique convoyée par un seul conducteur.

## Claims

1. A magnetic memory having each of its memory points formed of a magnetic tunnel junction (70), comprising:
• a so-called locked magnetic layer (71) having a rigid magnetization,
• a so-called free magnetic layer (73) having a magnetization that can be inverted,
• an insulating layer (72), interposed between the free layer (73) and the locked layer (71) and at the respective contact of these two layers,
**characterized in that** the free layer (73) is made of an amorphous or nanocrystallized alloy based on a rare earth and a transition metal, the magnetic order of said alloy being of ferrimagnetic type, and **in that** the magnetic memory comprises means (76) capable of selecting the operating temperature of the memory close to the compensation temperature of said alloy.

2. The magnetic memory of claim 1, **characterized in that** the free layer (73) is made of a gadolinium and cobalt alloy.

3. The magnetic memory of one of claims 1 and 2, **characterized in that** the free layer (73) further contains a small amount of one or several substitution elements.

4. The magnetic memory of claim 3, **characterized in that** the substitution elements are selected from the group comprising, for example, Zr, Ta, Mo, Nb, Dy, Sm, Pt.

5. The magnetic memory of one of claims 1 to 4, **characterized in that** the locked layer (71) is made of an amorphous alloy based on a rare earth and a transition metal, identical to or different from that constitutive of the free layer (73), the magnetic order in said alloy being of ferrimagnetic type.

6. The magnetic memory of claim 5, **characterized in that** the locked layer (71) is made of a terbium and cobalt based amorphous alloy.

7. The magnetic memory of one of claims 1 to 4, **characterized in that** the locked layer (71) is made of an amorphous alloy based on a rare earth and a transition metal, the magnetic order in said alloy being of ferromagnetic type.

8. The magnetic memory of claim 7, **characterized in that** the locked layer (71) is made of a samarium and cobalt alloy.

9. The magnetic memory of one of claims 1 to 8, **characterized in that** each memory point is placed at the intersection of a lattice of electric conductors (74, 75), a lower conductor (75) being electrically insulated from said memory points, each memory point being connected at its base to a pass transistor (76), the writing being performed in a considered memory point by the simultaneous sending of electric current pulses into said conductors (74, 75) and of a heating current via said transistor (76).

10. The magnetic memory of one of claims 1 to 9, **characterized in that** the temperature of the memory point upon writing is brought to a value greater than the compensation temperature (53) of the free layer (73) forming it.

11. A random access magnetic memory according to any of claims 1 to 10.

12. A method for writing into a magnetic memory according to claim 1,
each memory point being placed at the intersection of a lattice of electric conductors (74, 75), a lower conductor (75) being electrically insulated from said memory points, each memory point being connected at its base to a pass transistor (76),
**characterized in that** it comprises the steps of:
• selecting the operating temperature of the memory close to the compensation temperature of said alloy; and
• simultaneously sending, in the memory point to be written into, electric current pulses into said corresponding conductors (74, 75) and a heating current via said considered transistor (76).

13. A method for writing into a magnetic memory according to claim 1,
each of the memory points being placed at the intersection of a lattice of electric conductors (74, 75), said lower conductor (75) being electrically insulated from said memory points, each of them being connected at its base to a pass transistor (76),
**characterized in that** it comprises the steps of:
• selecting the operating temperature of the memory close to the compensation temperature of said alloy; and
• simultaneously sending, at the level of the memory point to be written into, electric current pulses into said corresponding conductors (74, 75) and, at the level of the memory points to be inhibited, said memory points to be inhibited (92) exhibiting the magnetization (80) of their free layer (73) oriented along the same direction as that of the free layer of the memory point to be written into (90), a heating current by the turning-off of the corresponding transistors (76) connected to the memory points to be inhibited, said heating current being selected so that the temperature of said memory points to be inhibited becomes greater than the compensation temperature of the ferrimagnetic alloy forming the free layer (73) of said memory points.

14. The method for writing into a magnetic memory of claim 13, **characterized in that** a magnetic field applied on the memory point to be written into by the electric current pulses transiting via the electric conductors (74, 75) has a much greater amplitude than the individual brick-over magnetic field of the magnetization of the free layer (73) of said memory point to be written into.

15. The method for writing into a magnetic memory according to one of claims 13 and 14, **characterized in that** several memory points are simultaneously written into.

16. The method for writing into a magnetic memory appearing in the form of an array, according to one of claim 13 to 15, **characterized in that** the writing into all the memory points of one of the two memory states (directions) is simultaneously performed.

17. The method for writing into a magnetic memory according to claim 16, **characterized in that** the entire memory is written into in two operations:
• a first operation in which the memory points are written into in a given direction;
• a second operation in which the memory points are written into in the other direction.

18. The method for writing into a magnetic memory according to claim 13, **characterized in that** the writing on each of the memory points is obtained by an electric current pulse carried by a single conductor.

## Patentansprüche

1. Magnetspeicher, bei dem jeder Speicherpunkt aus einem magnetischen Tunnelübergang (70) gebildet ist, mit folgenden Merkmalen:
• eine sogenannte verriegelte Magnetschicht (71) mit einer starren Magnetisierung,
• eine sogenannte freie Magnetschicht (73) mit einer Magnetisierung, die invertiert werden kann,
• eine Isolationsschicht (72), die zwischen der freien Schicht (73) und der verriegelten Schicht (71) liegt und jeweils mit diesen beiden Schichten in Kontakt ist,
**dadurch gekennzeichnet, daß** die freie Schicht (73) aus einer amorphen oder nanokristallinen Legierung auf der Basis einer Seltenerde und eines Übergangsmetalls hergestellt ist, wobei die magnetische Ordnung dieser Legierung ferrimagnetisch ist, und daß der Magnetspeicher Mittel (76) aufweist, die zum Auswählen der Betriebstemperatur des Speichers nahe der Ausgleichstemperatur der Legierung geeignet ist

2. Magnetspeicher nach Anspruch 1, **dadurch gekennzeichnet, daß** die freie Schicht (73) aus einer Gadolinium- und Kobaltlegierung hergestellt ist

3. Magnetspeicher nach einem der Ansprüche 1 und 2, **dadurch gekennzeichnet, daß** die freie Schicht (73) ferner eine geringe Menge eines oder mehrerer Ersatzelemente aufweist.

4. Magnetspeicher nach Anspruch 3, **dadurch gekennzeichnet, daß** die Ersatzelemente aus einer Gruppe ausgewählt sind, die zum Beispiel Zr, Ta, Mo, Nb, Dy, Sm, Pt umfaßt

5. Magnetspeicher nach einem der Ansprüche 1 bis 4, **dadurch gekennzeichnet, daß** die verriegelte Schicht (71) aus einer amorphen Legierung auf der Basis einer Seltenerde und eines Übergangsmaterials hergestellt ist, welche zu der die freie Schicht (73) bildenden identisch ist oder sich von dieser unterscheidet, wobei die magnetische Ordnung der Legierung ferrimagnetisch ist.

6. Magnetspeicher nach Anspruch 5, **dadurch gekennzeichnet, daß** die verriegelte Schicht (71) aus einer amorphen Legierung auf der Basis von Terbium und Kobalt hergestellt ist

7. Magnetspeicher nach einem der Ansprüche 1 bis 4, **dadurch gekennzeichnet, daß** die verriegelte Schicht (71) aus einer amorphen Legierung auf der Grundlage einer Seltenerde und eines Übergangsmaterials hergestellt ist, wobei die magnetische Ordnung der Legierung ferromagnetisch ist

8. Magnetspeicher nach Anspruch 7, **dadurch gekennzeichnet, daß** die verriegelte Schicht (71) aus einer Samarium- und Kobaltlegierung hergestellt ist.

9. Magnetspeicher nach einem der Ansprüche 1 bis 8, **dadurch gekennzeichnet, daß** jeder der Speicherpunkte an der Schnittstelle eines Gitters aus elektrischen Leitern (74, 75) liegt, wobei der untere Leiter (75) gegenüber den Speicherpunkten elektrisch isoliert ist und jeder der Speicherpunkte mit seiner Basis mit einem Auswahltransistor (76) verbunden ist, wobei das Schreiben bei einem betrachteten Speicherpunkt durch das gleichzeitige Senden von elektrischen Stromimpulsen in die Leiter (74, 75) und eines Heizstroms über den Transistor (76) erfolgt.

10. Magnetspeicher nach einem der Ansprüche 1 bis 9, **dadurch gekennzeichnet, daß** die Temperatur des Speicherpunkts beim Schreiben auf einen Wert gebracht wird, der größer ist als die Ausgleichstemperatur (53) der freien Schicht (73), welche ihn bildet

11. Magnetspeicher mit wahlfreiem Zugriff nach einem der Ansprüche 1 bis 10

12. Verfahren zum Schreiben in einen Magnetspeicher nach Anspruch 1, wobei jeder Speicherpunkt an der Schnittstelle eines Gitters aus elektrischen Leitern (74, 75) liegt, wobei der untere Leiter (75) gegenüber den Speicherpunkten elektrisch isoliert ist und jeder Speicherpunkt mit seiner Basis mit einem Auswahltransistor (76) verbunden ist, **gekennzeichnet durch** die folgenden Verfahrensschritte
• Auswählen der Betriebstemperatur des Speichers nahe bei der Ausgleichstemperatur der Legierung; und
• gleichzeitiges Senden, auf Höhe des zu beschreibenden Speicherpunktes, elektrischer Stromimpulse in die entsprechenden Leiter (74, 75) und eines Heizstroms über den betrachteten Transistor (76)

13. Verfahren zum Schreiben in einen Magnetspeicher nach Anspruch 1,
wobei jeder der Speicherpunkte an der Schnittstelle eines Gitters aus elektrischen Leitern (74, 75) liegt, wobei der untere Leiter (75) gegenüber den Speicherpunkten elektrisch isoliert ist und jeder der Speicherpunkte mit seiner Basis mit einem Auswahltransistor (76) verbunden ist, **gekennzeichnet durch** die folgenden Verfährensschritte:
• Auswählen der Betriebstemperatur des Speichers nahe bei der Ausgleichstemperatur der Legierung; und
• gleichzeitiges Senden, auf Höhe der zu beschreibenden Speicherpunkte, elektrischer Stromimpulse in die entsprechenden Leiter (74, 75) und, auf Höhe der zu sperrenden Speicherpunkte, wobei die zu sperrenden (92) Speicherpunkte eine Magnetisierung (80) ihrer freien Schicht (73) aufweisen, die entlang derselben Richtung orientiert ist wie die der freien Schicht der zu beschreibenden Speicherpunkte (90), eines Heizstroms **durch** Öffnen der entsprechenden Transistoren (76), welche mit den zu sperrenden Speicherpunkten verbunden sind,
wobei der Heizstrom so gewählt wird, daß die Temperatur der zu sperrenden Speicherpunkte höher wird als die Ausgleichstemperatur der ferrimagnetischen Legierung, welche die freie Schicht (73) der Speicherpunkte bildet.

14. Verfahren zum Schreiben in einen Magnetspeicher nach Anspruch 13, **dadurch gekennzeichnet, daß** ein an den Speicherpunkt, welcher durch die durch die elektrischen Leiter (74, 75) gehenden elektrischen Stromimpulse beschrieben wird, angelegtes Magnetfeld eine wesentlich größere Amplitude hat als das individuelle magnetische Umkehrfeld der Magnetisierung der freien Schicht (73) des zu beschreibenden Speicherpunktes

15. Verfahren zum Schreiben in einen Magnetspeicher nach einem der Ansprüche 13 und 14, **dadurch gekennzeichnet, daß** mehrere Speicherpunkte gleichzeitig beschrieben werden.

16. Verfahren zum Schreiben in einen Magnetspeicher, der in der Form einer Matrix ausgebildet ist, gemäß einem der Ansprüche 13 bis 15, **dadurch gekennzeichnet, daß** einer der beiden Speicherzustände (Richtungen) des Speichers gleichzeitig in die Gesamtheit der Speicherpunkte geschrieben wird.

17. Verfahren zum Schreiben in einen Magnetspeicher nach Anspruch 16, **dadurch gekennzeichnet, daß** der gesamte Speicher in zwei Operationen beschrieben wird:
• eine erste Operation, in der die Speicherpunkte in eine gegebene Richtung beschrieben werden,
• eine zweite Operation, in der die Speicherpunkte in die andere Richtung beschrieben werden.

18. Verfahren zum Schreiben in einen Magnetspeicher nach Anspruch 13, **dadurch gekennzeichnet, daß** das Beschreiben jedes der Speicherpunkte durch einen elektrischen Stromimpuls, welcher durch einen einzelnen Leiter geführt wird, erzielt wird
